# EUROPEAN PATENT APPLICATION

(11) **EP 1 061 576 A2**
(43) Date of publication of application: **20.12.2000**
(21) Application number: 00112781.0
(22) Date of filing: 16.06.2000
(51) Int. Cl.: H01L 23/498

(54) **Semiconductor package and its manufacturing method**

(30) Priority: 18.06.1999 JP 17319999
(71) Applicant: SONY CORPORATION, Tokyo (JP)
(72) Inventor: Ito, Mutsuyoshi, c/o Sony Corporation, Tokyo (JP); Ogura, Hisao, c/o Sony Corporation, Tokyo (JP); Ohta, Kentaro, c/o Sony Neagari Corporation, Nomi-gun, Ishikawa (JP); Kazuhiko, Ishino c/o Sony Neagari Corporation, Nomi-gun, Ishikawa (JP)
(74) Representative: MÜLLER & HOFFMANN Patentanwälte

(57) **Abstract**

To provide a semiconductor device and its manufacturing method capable of enhancing the mounting strength.

A semiconductor device has a substrate provided with through-holes 6A, 6B for mounting, on which a semiconductor chip is mounted. The inner circumference of the through-holes 6A for reinforcement of mounting out of the through-holes is formed as being exposed to the side surface direction of the substrate.

## Description

### BACKGROUND OF THE INVENTION

### Field of the Invention

The present invention relates to a semiconductor device and its manufacturing method, and more particularly to a semiconductor device having semiconductor chips mounted on a substrate, and its manufacturing method.

### Description of the Related Art

Recently, cellular telephones and mobile devices, such as PHS (personal handy phone system) and PDA (personal digital assistant), and many other electronic appliances are being developed. These electronic appliances are becoming smaller in size and lighter in weight for the convenience of portable use by the users.

The LSI chips for composing such electronic appliances are also required to be smaller in size, higher in density, and lighter in weight, and the CSP (chip size package) is being used because it can be mounted on a mother board or the like nearly in the same size as the semiconductor chip forming the LSI.

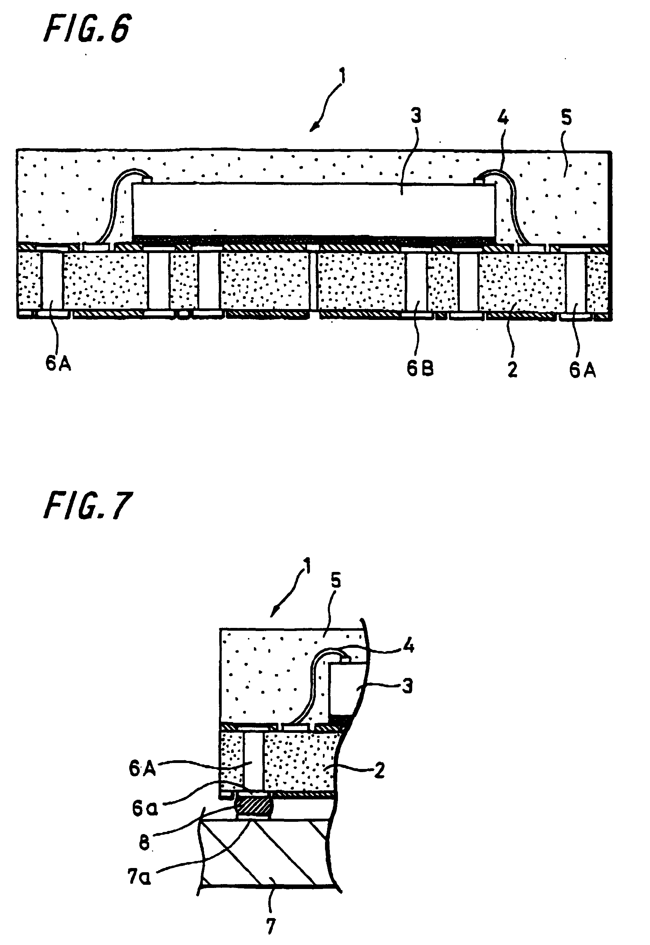

FIG. 6 is a sectional view showing an example of a conventional semiconductor device.

This semiconductor device 1 is a CSP comprising a substrate 2, a semiconductor chip (die) 3, a wiring 4, a sealing layer 5, and others.

Plural through-holes 6A, 6B are formed in the substrate 2, and peripheral edges of both ends and inner circumference of each through-holes 6A, 6B are plated with metal.

The semiconductor chip 3 forms an integrated circuit comprising passive elements and active elements, and it is adhered on the substrate 2 by means of, for example, an adhesive agent. The substrate 2 and semiconductor chip 3 are electrically connected by way of the wiring 4. The semiconductor chip 3, wiring 4 and others on the substrate 2 are covered and sealed with the sealing layer 5.

When mounting the semiconductor device 1 having such constitution on a mother board, as shown in FIG. 7, lands 6a which are metal plated films formed on the lower end peripheral edge of the through-holes 6A, 6B are bonded to lands 7a formed on the mother board 7 through solder 8.

At this time, of the plural through-holes 6A, 6B, for example, the through-holes 6A at four corners function as reinforcing parts when mounting the semiconductor device 1 on the mother board 7, and the other through-holes 6B function as electrodes for connecting electrically the substrate 2 and semiconductor chip 3, and the substrate 2 and mother board 7.

### SUMMARY OF THE INVENTION

In the conventional semiconductor device 1 described above, the lands 6a of the through-holes 6A, 6B are formed like disks. The lands 7a on the mother board 7 are also formed like disks. Therefore, the solder 8 of the through-holes 6A functioning as reinforcing parts when mounted on the mother board 7 is formed like a croquette contacting with the lands 6a, 7a at both ends as shown in Fig. 7.

In this way, since the semiconductor device 1 and mother board 7 are bonded face to face, it is strong against the tensile force applied between the semiconductor device 1 and mother board 7, but it is less resistant to shearing force.

For example, in the key pushing stress test by pushing the button of a cellular telephone to apply a bending stress to the mother board, transmitting this bending stress to the reinforcing parts of the semiconductor device on the mother board, and counting the number of times of pushing the button until the solder is broken by fatigue, the limit of life is 8,000 times.

It is hence an object of the invention to solve the above problems, and present a semiconductor device and its manufacturing method capable of enhancing the mounting strength.

The object is achieved by the semiconductor device of the invention which comprises a substrate having through-holes of mounting composed of a through-hole for reinforcement of mounting and a through-hole for electrical connection, and semiconductor chips to be mounted on the substrate, in which the inner circumference of the through-hole for reinforcement of mounting is formed as being exposed to the direction of the side surface of the substrate.

The object is also achieved by the manufacturing method of semiconductor device of the invention which comprises a substrate having through-holes of mounting composed of a through-hole for reinforcement of mounting and a through-hole for electrical connection, and semiconductor chips to be mounted on the substrate, in which subsidiary substrates are adhered to four corners of the substrate so as to cover the through-hole for reinforcement of mounting, the semiconductor chip is die-bonded on the substrate, the semiconductor chip is wire-bonded to the substrate, the semiconductor chip and subsidiary substrates are sealed by a sealing agent, and the substrate, subsidiary substrates, and sealing agent are cut off along a line linking the centers of the through-holes for reinforcement of mounting.

The object is also achieved by the manufacturing method of semiconductor device comprising a substrate having through-holes of mounting composed of a through-hole for reinforcement of mounting and a through-hole for electrical connection, and semiconductor chips to be mounted on the substrate, in which the semiconductor chip is mounted on the substrate by flip-chip, and the substrate is cut off along a line linking the centers of the through-holes for reinforcement of mounting.

According to such constitution, since the inner circumference of the through-holes for reinforcement of mounting are formed as being exposed in the direction of the side surface of the substrate, when the substrate is connected, for example, to the mother board by way of solder, the solder can permeate into the inner circumference of the through-holes. Accordingly, the wetting area of the solder spreads widely, so that the mounting strength of the semiconductor device can be notably enhanced.

### BRIEF DESCRIPTION OF THE DRAWINGS

FIG. 1 is a partial sectional perspective view showing an embodiment of a semiconductor device of the invention;
FIG. 2 is a partial side view when the semiconductor device in FIG. 1 is mounted on a mother board;
FIG. 3 is a process chart showing an embodiment of manufacturing method of semiconductor device of the invention;
FIG. 4 is a first plan showing a state of the semiconductor device in the midst of process of manufacturing method of semiconductor device in FIG. 3;
FIG. 5 is a second plan showing a state of the semiconductor device in the midst of process of manufacturing method of semiconductor device in FIG. 3;
FIG. 6 is a sectional view showing an example of a conventional semiconductor device; and
FIG. 7 is a partial side view when the semiconductor device in FIG. 6 is mounted on a mother board.

### DESCRIPTION OF THE PREFERRED EMBODIMENTS

A preferred embodiment of the invention is described in detail below while referring to the accompanying drawings.

The embodiment, which is described below, is a preferred example of the invention, and is shown with various technically preferable conditions, but it must be noted that the invention is not limited to the illustrated modes alone unless restrictive conditions are given in the following description.

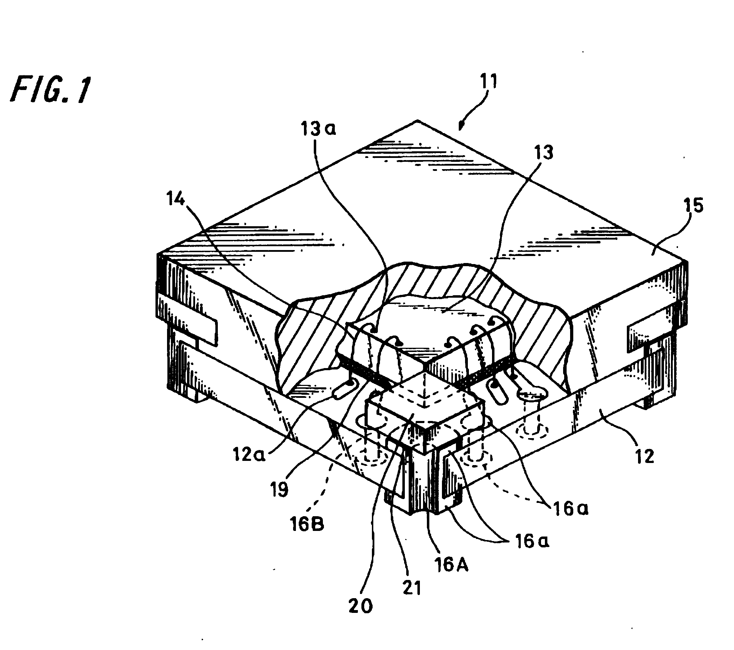

FIG. 1 is a partial sectional perspective view showing an embodiment of a semiconductor device of the invention.

This semiconductor device 11 is a CSP comprising a substrate 12, a semiconductor chip (die) 13, a wiring 14, a sealing layer 15, and others.

The substrate 12 is a rectangular resin plate of, for example, glass epoxy, and bonding pads 12a are formed on the surface of the substrate 12 by, for example, copper plating and nickel-gold plating.

The semiconductor chip 13 is an integrated circuit composed of passive elements and active elements, and it is adhered on the substrate 12 by way of, for example, an epoxy adhesive agent 19. The substrate 12 and semiconductor chip 13 are electrically connected by connecting the bonding pads 12a of the substrate 12 and terminals 13a of the semiconductor chip 13 through the wiring 14 made of, for example, gold. The semiconductor chip 13, wiring 14 and others on the substrate 12 are covered and sealed with the sealing layer 15 made of, for example, an epoxy resin.

The substrate 12 further has plural cylindrical through-holes 16A, 16B. Peripheral edges at both ends and inner circumference of each through-holes 16A, 16B are provided with, for example, copper plating and nickel-gold plating, and peripheral edges at both ends are formed as lands 16a. Of the plural through-holes 16A, 16B, for example, the through-holes 16A at four corners function as reinforcing parts when mounting the semiconductor device 11 on the mother board, and the other through-holes 16B function as electrodes for connecting the substrate 12 and semiconductor chip 13, and the substrate 12 and mother board electrically.

A characteristic aspect of the semiconductor device 11 of the embodiment lies in the shape of the through-holes 16A at four corners functioning as reinforcing parts when mounting the semiconductor device 11 on the mother board.

The shape of each through-hole 16A is, different from the shape of the other through-holes 16B, a 1/4 cylindrical form in the axial direction, that is, a side-through structure having the inner circumference exposed to the side surface side of the substrate 12.

Further, on the substrate 12 in the upper part of each through-hole 16A, a subsidiary substrate 20 of rectangular parallelepiped made of resin plate of, for example, glass epoxy is adhered by way of an adhesive agent 21 of, for example, epoxy. This subsidiary substrate 20 has a function of preventing the through-holes 16A from becoming a side-through structure, that is, a function of preventing the sealing resin from flowing into the through-holes 16A to fill up the through-holes 16A when forming the sealing layer 15.

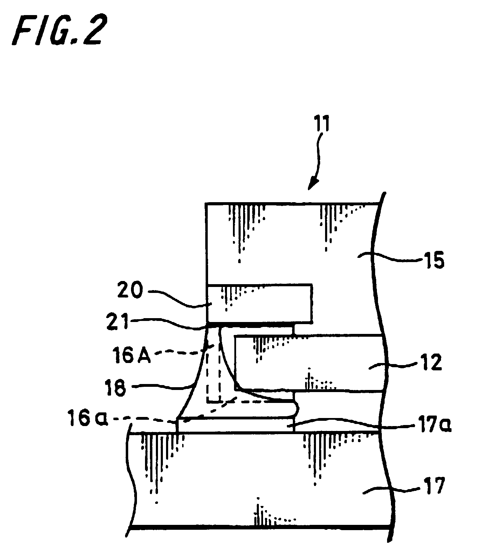

When the through-holes 16A of side-through structure of the semiconductor device 11 having such constitution are bonded with the lands formed on the mother board through solder, as shown in FIG. 2, the solder 18 wets and spreads widely not only onto the surface (horizontal plane) of the lands 16a formed in the lower end peripheral edge of the through-holes 16A, but also onto the inner circumference (vertical plane) of the through-holes 16A.

Accordingly, the solder 18 envelops from the surface of the lands 17a of the mother board 17 to the surface and inner circumference of the lands 16a of the through-holes 16A, and the side-through portion is formed like a fillet. Thus, the semiconductor device 11 and mother board 17 are bonded solidly, and the structure is strong not only against the tensile force but also against the shearing force applied between the semiconductor device 11 and mother board 17.

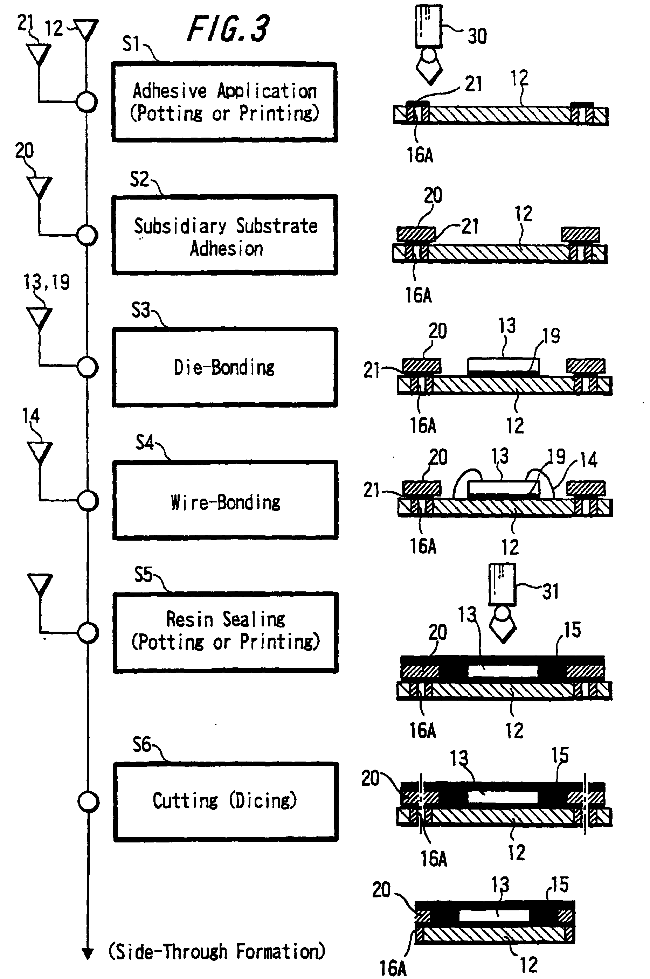

FIG. 3 is a process chart showing an embodiment of a manufacturing method of semiconductor device of the invention.

An integrated circuit is formed on a wafer, and this wafer is diced (cut) into a specified size, and a semiconductor chip 13 is fabricated. On the other hand, the substrate 12 on which this semiconductor chip 13 is to be mounted is fabricated by thin film forming technique such as vacuum deposition, sputtering, or ion plating, or photolithography, and etching, etc.

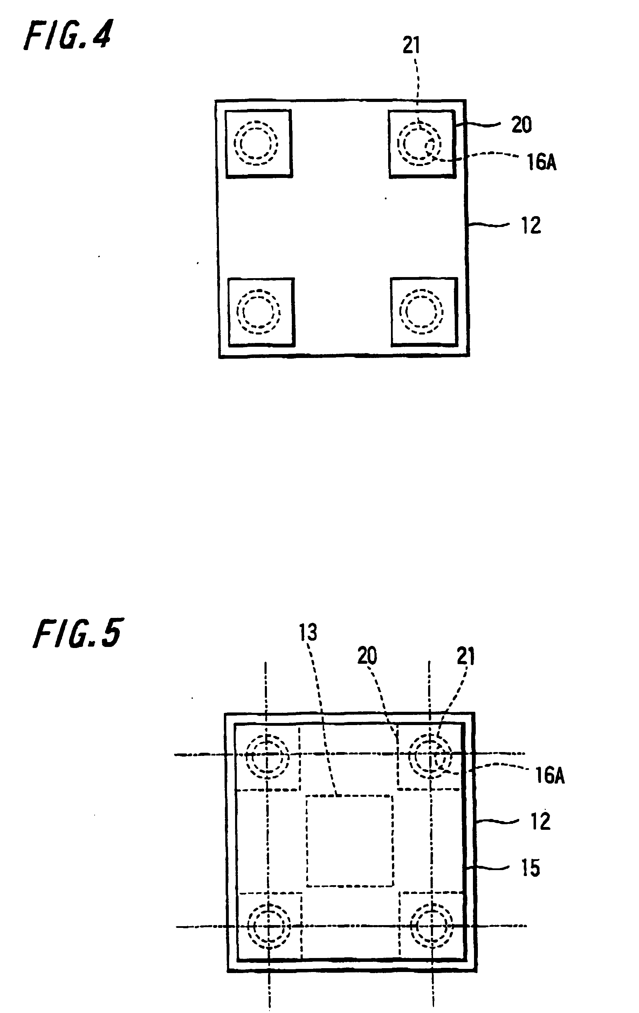

First, an adhesive agent 21 is applied on the upper end peripheral edges of the through-holes 16A of the substrate 12 by using a nozzle 30 (step S1). The frame substrate 20 is put on this adhesive agent 21, and the adhesive agent 21 is cured by heating and pressing, and the subsidiary substrate 20 is adhered to the substrate 12 (step S2). FIG. 4 is a plan showing the configuration of the substrate 12 and frame substrate 20 at this time, in which the subsidiary substrate 20 is fixed through the adhesive agent 21 so as to cover the through-holes 16A provided at four corners of the substrate 12.

Next, the semiconductor chip 13 is put nearly on the center of the substrate 12 through an adhesive agent 19, and the adhesive agent 19 is cured by heating and pressing, so that the semiconductor chip 13 is die-bonded on the substrate 12 (step S3). Bonding pads 12a of the substrate 12 and terminals 13a of the semiconductor chip 13 are wire-bonded by means of wiring 14 (step S4).

In succession, so as to cover the semiconductor chip 13, wiring 14, subsidiary substrate 20 and others on the substrate 12, a sealing resin is poured in by using a nozzle 31, and the sealing resin is cured by heating, so that the semiconductor chip 13, wiring 14, subsidiary substrate 20 and others are sealed by a sealing layer 15 (step S5). The substrate 12 sealed with the sealing layer 15 is diced (cut) along the line linking the centers of each through-holes 16A indicated by twin dot chain line in FIG. 5 (step S6). As a result, the semiconductor device 11 having through-holes 16A in side-through structure as shown in FIG. 1 is completed.

In the cellular telephone having the semiconductor device 11 of such structure, the set key durability test proves a high value of more than 10000 times.

The foregoing embodiment is an example of CSP having the semiconductor chip and substrate connected by wire bonding, but not limited to this, and as far as the semiconductor device has a substrate, it may be also applied, for example, to a CSP having the semiconductor chip mounted on the substrate by flip-chip through solder ball or Au bump. It may be further applied to the semiconductor device having a stress applied between it and the mother board to be mounted on.

In the example of the CSP having the semiconductor chip mounted on the substrate by flip-chip through Au bump, the semiconductor chip 13 is mounted on the substrate 12 having the through-holes 16A, 16B by flip-chip through Au bump. In this case, the semiconductor chip 13 is fixed by the sealing layer 15, but the sealing layer 15 itself is formed only in the peripheral area of the semiconductor chip 13, and hence it does not cover the side through-hole 16A for reinforcement of mounting, which means that the subsidiary substrate is not required as compared with the case of mounting of semiconductor chip by die bonding or wire bonding.

As described herein, according to the invention, the mounting strength is notably enhanced, and the reliability of the electronic appliance incorporating the semiconductor device can be remarkably improved.

Having described preferred embodiments of the present invention with reference to the accompanying drawings, it is to be understood that the present invention is not limited to the above-mentioned embodiments and that various changes and modifications can be effected therein by one skilled in the art without departing from the spirit or scope of the present invention as defined in the appended claims.

## Claims

1. A semiconductor device comprising a substrate having through-holes of mounting composed of a through-hole for reinforcement of mounting and a through-hole for electrical connection, and semiconductor chips to be mounted on said substrate, wherein:
the inner circumference of the through-hole for reinforcement of mounting is formed as being exposed to the direction of the side surface of said substrate.

2. The semiconductor device of claim 1, wherein a subsidiary substrate for preventing sealing agent for sealing said semiconductor chip from flowing into said through-hole for reinforcement of mounting is disposed so as to cover said through-hole for reinforcement of mounting.

3. The semiconductor device of claim 2, wherein said subsidiary substrate is a rectangular parallelepiped.

4. The semiconductor device of claim 1, wherein said through-hole for reinforcement of mounting is disposed at four corners of said substrate.

5. The semiconductor device of claim 1, wherein said semiconductor chips are mounted on said substrate by die bonding and wire bonding.

6. The semiconductor device of claim 1, wherein said semiconductor chips are mounted on said substrate by flip-chip mounting.

7. A manufacturing method of semiconductor device having a substrate having through-holes of mounting composed of a through-hole for reinforcement of mounting at four corners of said substrate and a through-hole for electrical connection, and semiconductor chips to be mounted on said substrate, comprising steps of:
adhering subsidiary substrates to four corners of said substrate so as to cover said through-hole for reinforcement of mounting,
die-bonding said semiconductor chip on said substrate,
wire-bonding said semiconductor chip to said substrate,
sealing said semiconductor chip and subsidiary substrates by a sealing agent, and
cutting off said substrate, subsidiary substrates, and sealing agent along a line linking the centers of said through-holes for reinforcement of mounting.

8. The manufacturing method of semiconductor device of claim 7, wherein said subsidiary substrate is a rectangular parallelepiped.

9. A manufacturing method of semiconductor device having a substrate having through-holes of mounting composed of
a through-hole for reinforcement of munting
at four corners of said substrate and a through-hole
for electrical connection, and semiconductor chips to be mounted on said substrate, comprising steps of:
mounting said semiconductor chip on said substrate by flip-chip, bonding said semiconductor chip on said substrate with bump, and
cutting off said substrate along a line linking the centers of said through-holes for reinforcement of mounting.
